# FASCICULE DE BREVET EUROPEEN

(11) **EP 3 656 193 B1**
(45) Date de publication et mention de la délivrance du brevet: **07.07.2021**
(21) Numéro de dépôt: 18738367.4
(22) Date de dépôt: 17.07.2018
(51) Int. Cl.: H05K 7/20, H05K 9/00, H01Q 1/32

(54) **DISPOSITIF DE TÉLÉMATIQUE EMBARQUÉE À REFROIDISSEMENT INTÉGRÉ POUR VÉHICULE AUTOMOBILE**
BORDEIGENE TELEMATISCHE VORRICHTUNG MIT INTEGRIERTER KÜHLUNG FÜR EIN KRAFTFAHRZEUG
ON-BOARD TELEMATIC DEVICE WITH INTEGRATED COOLING FOR A MOTOR VEHICLE

(30) Priorité: 17.07.2017 FR 1756748
(43) Date de publication de la demande: 27.05.2020
(73) Titulaire: Valeo Comfort and Driving Assistance, 94046 Créteil Cedex (FR)
(72) Inventeur: KLEIN, Patrick, 94046 Créteil Cedex (FR); CURCIO, Renato, 94046 Créteil Cedex (FR)
(74) Mandataire: Delaval, Guillaume Laurent
(86) Numéro de dépôt international: PCT/EP2018/069445
(87) Numéro de publication internationale: WO 2019/016239

(56) Documents cités:
- WO-A1-2017/076750
- US-A1- 2002 154 487
- US-A1- 2015 123 854

## Description

La présente invention concerne de manière générale les dispositifs de télématique embarquée destinés à équiper les véhicules automobiles, et plus précisément le refroidissement de composants électroniques de puissance intégrés dans de tels dispositifs de télématique embarquée.

Les dispositifs de télématique embarquée comportent de plus en plus de fonctions à forte dissipation de puissance utilisant des composants à faible tolérance en température. A titre d'exemple, un dispositif télématique avec une fonctionnalité de type NAD (initiales anglo-saxonnes mises pour Network Access Device), intégrant un modem cellulaire, peut dissiper plusieurs Watts en puissance, avec des températures de jonction des composants qui doivent être inférieures à 120 degrés Celsius.

La conception d'un dispositif de télématique embarquée peut s'avérer complexe en termes de gestion de la dissipation de puissance thermique, tout particulièrement lorsque le dispositif doit être placé dans des endroits du véhicule automobile susceptibles d'être soumis à de fortes températures, comme par exemple sous le toit du véhicule où la température ambiante peut avoisiner les 95 degrés Celsius.

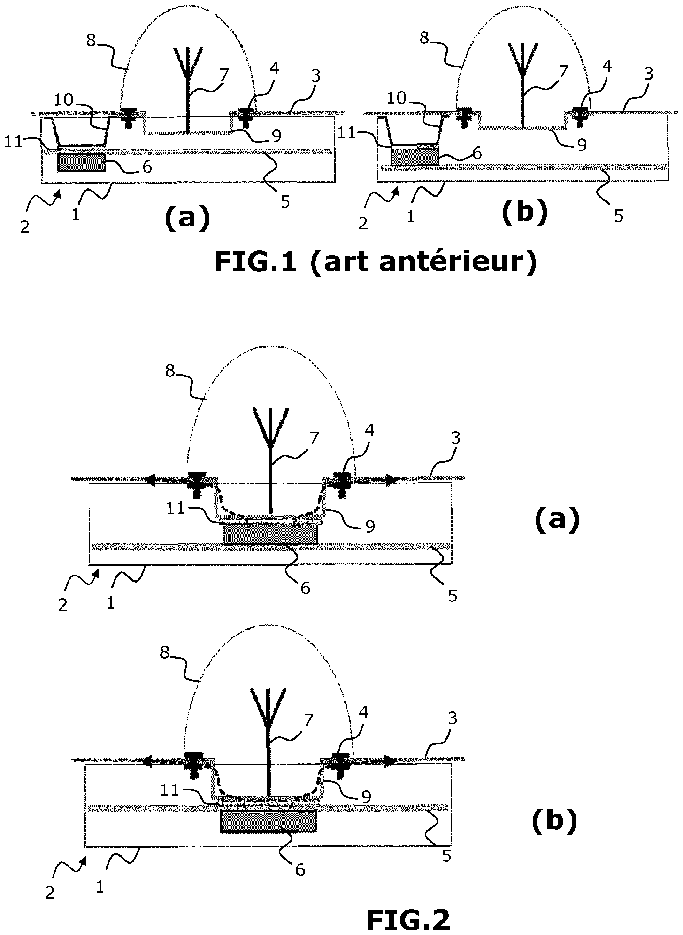

Un moyen classique pour refroidir un composant électronique de puissance est d'utiliser un dissipateur thermique intégré dans le dispositif de télématique embarqué, comme schématisé sur la figure 1. Sur cette figure, un boîtier 1 d'un dispositif 2 de télématique embarquée est illustré fixé sous le toit 3 d'un véhicule automobile au moyen de vis 4 de fixation. Le dispositif 2 comporte, intégrés dans le boîtier 1, une carte 5 de circuit imprimée et un composant 6 d'électronique de puissance assemblé sur la carte 5 de circuit imprimé. Le composant 6 d'électronique de puissance peut être assemblé sur la face supérieure de la carte 5 de circuit imprimée (cas de la figure 1(a)), ou sur sa face inférieure (cas de la figure 1 (b)). Le dispositif comporte en outre, pour assurer des échanges de données avec l'extérieur, une antenne 7 d'émission/réception radiofréquence, qui s'étend verticalement à l'extérieur, au travers d'une ouverture prévue dans la carrosserie, de manière à émerger au travers du toit 3. Un radôme 8 vient de préférence protéger l'antenne contre les infiltrations. Un écran 9 métallique interposé entre la partie inférieure de l'antenne 7 d'une part, et la carte 5 de circuit imprimé et les composants qu'elle porte d'autre part, permet d'isoler l'antenne des composants électroniques dont les émissions parasites viendraient affecter les performances en émission/réception de l'antenne. Cet écran 9 métallique est généralement fixé au niveau du toit 3, également métallique, par exemple par les mêmes vis 4 de fixation que celles servant au maintien du boîtier 1, afin de procurer un bon contact électrique et assurer ainsi une continuité au blindage réalisé par l'écran 9. Plus précisément, l'écran 9 métallique comporte un rebord s'appuyant sur une face externe du boîtier 1 et périphérique à l'ouverture, et le dispositif est apte à être fixé sur la partie métallique par les vis de fixation traversant ensemble le rebord et la face externe du boîtier. Enfin, pour assurer le refroidissement du composant 6 d'électronique de puissance, le boîtier 1 intègre, au droit du composant et en contact thermique avec une face interne de la partie supérieure du boîtier, un dissipateur thermique 10, dont les parties métalliques viennent augmenter les échanges thermiques entre le composant 6 et l'air, et limiter ainsi une augmentation en température du composant. Une couche 11 formant interface thermique est de préférence interposée entre la partie inférieure du dissipateur thermique 10 et la partie supérieure du composant (cas (b)) ou la carte de circuit imprimée (cas (a)) pour favoriser les échanges thermiques.

Dans une autre réalisation connue, le dissipateur thermique 10 est remplacé par un tube caloduc permettant des échanges thermiques entre le composant 6 et d'autres éléments externes (non représentés).

Ces solutions connues ont toutes un impact en termes de coût, d'encombrement et de poids en nécessitant l'adjonction d'un dissipateur thermique ou d'un tube caloduc.

Dans d'autres réalisations connues qui évitent l'utilisation du dissipateur thermique 10, le boîtier 1 est choisi dans un matériau à bonne conductivité thermique, et conformé au droit du composant 6 pour réaliser la même fonction de refroidissement que le dissipateur thermique 10.

Cette solution reste néanmoins coûteuse en raison du choix du matériau à bonne conductivité thermique qu'il faut alors utiliser pour l'intégralité du boîtier.

D'autres exemples de l'art antérieur sont également connus:
US 2015/123854 décrit un module d'antenne comportant un élément d'antenne d'émission et de réception.

WO 2017/076750 décrit un appareil télématique multi-réseaux avec plusieurs antennes.

US 2002/154487 décrit un module de radiofréquence d'un appareil audio ayant une dissipation thermique optimale.

La présente invention a pour but de pallier les inconvénients des solutions jusqu'ici proposées.

Ce but est atteint selon l'invention qui a pour objet un dispositif de télématique embarquée destiné à être fixé sur une partie métallique d'une carrosserie de véhicule automobile, comportant un boîtier intégrant une carte de circuit imprimé dont une face porte au moins un composant d'électronique de puissance, une antenne d'émission/réception radiofréquence, destinée à s'étendre au travers d'une ouverture de la partie métallique et un écran métallique interposé entre une partie inférieure de l'antenne d'une part, et la carte de circuit imprimé et ledit au moins un composant, pour isoler l'antenne d'émissions parasites, ledit écran étant destiné à être fixé entre ladite partie métallique et le boîtier de façon à assurer une continuité électrique, dispositif dans lequel ledit au moins un composant est placé au droit de l'écran métallique et en contact thermique avec une portion dudit écran, et ledit écran est en matériau conducteur thermique de façon à former un moyen de transfert thermique entre le composant d'électronique de puissance et la partie métallique.

Outre les caractéristiques principales qui viennent d'être mentionnées dans le paragraphe précédent, le procédé selon l'invention peut présenter une ou plusieurs caractéristiques complémentaires parmi les suivantes :
- l'écran métallique comporte de préférence un rebord s'appuyant sur une face externe du boîtier et périphérique à l'ouverture, et le dispositif est apte à être fixé sur la partie métallique par des vis de fixation traversant ensemble ledit rebord et la face externe du boîtier ;
- le matériau conducteur possède de préférence une conductivité thermique supérieure ou égale à 50 W.m⁻¹.K⁻¹;
- le matériau conducteur est par exemple de l'acier, de l'aluminium, ou du zamak ;
- dans un mode de réalisation, ledit au moins un composant d'électronique de puissance est supporté par une face de la carte de circuit imprimé directement en regard avec la portion dudit écran, et une couche formant interface thermique est interposée entre une partie inférieure de la portion dudit écran et la partie supérieure dudit composant ;
- en variante, ledit au moins un composant d'électronique de puissance est supporté par une première face de la carte de circuit imprimé opposée à une deuxième face de la carte directement en regard avec la portion dudit écran, et une couche formant interface thermique est interposée entre une partie inférieure de la portion dudit écran et la première face de la carte de circuit imprimée ;
- dans un autre mode de réalisation, le rebord de l'écran métallique s'étend parallèlement à la carte de circuit imprimé de manière à former une face dudit boîtier ;
- ledit rebord peut comporter une projection s'étendant vers l'intérieur du boîtier, avec une portion inférieure de ladite projection placée au droit de et en contact thermique avec un autre composant d'électronique de puissance porté par ladite carte de circuit imprimé.

L'invention sera mieux comprise à la lecture de la description qui suit, faite en référence aux figures annexées, dans lesquelles :
- la figure 1, déjà décrite ci-avant, illustre schématiquement deux dispositifs de télématique embarquée à refroidissement intégré d'un composant d'électronique de puissance, dans une position de fixation au toit d'un véhicule automobile ;
- la figure 2 illustre schématiquement un premier mode de réalisation d'un dispositif de télématique selon l'invention, dans une position de fixation au toit d'un véhicule automobile, et selon deux variantes de réalisation ;
- la figure 3 illustre schématiquement un deuxième mode de réalisation d'un dispositif de télématique selon l'invention, dans une position de fixation au toit d'un véhicule automobile.

Dans l'ensemble des figures, les différents éléments communs portent les mêmes références.

Le principe de l'invention repose sur la présence dans un dispositif 2 de télématique embarquée tel que décrit précédemment en référence à la figure 1, de l'écran métallique 9 utilisé en première fonctionnalité pour protéger l'antenne 7 de communication radiofréquence des perturbations générées par les composants électroniques du dispositif. Conformément à l'invention, on propose d'affecter une seconde fonctionnalité à cet écran en l'utilisant également comme vecteur d'énergie thermique entre le composant d'électronique de puissance et la portion métallique de la carrosserie du véhicule, par exemple le toit du véhicule, sur laquelle le dispositif doit être fixé.

Ce faisant, l'écran 9 métallique devient un conducteur thermique et amène la chaleur à dissiper jusqu'à la portion métallique de carrosserie qui sert alors de dissipateur thermique.

Un premier mode de réalisation va à présent être décrit en référence à la figure 2, qui représente un dispositif 2 de télématique embarquée, déjà fixé à la portion métallique de la carrosserie du véhicule, ici le toit 3. Ce dispositif comporte tous les éléments déjà décrits en référence à la figure 1. A la différence de cette figure 1 néanmoins, le composant 6 à électronique de puissance dont il convient d'assurer le refroidissement est placé au droit de l'écran 9 métallique et en contact thermique avec une portion de cet écran. De plus, l'écran 9 est réalisé en matériau conducteur thermique de façon à former un moyen de transfert thermique entre le composant 6 d'électronique de puissance et la partie métallique 3.

Le matériau conducteur est choisi de préférence parmi les matériaux métalliques possédant une conductivité thermique supérieure ou égale à 50 W.m⁻¹.K⁻¹. On peut par exemple utiliser de l'acier, de l'aluminium, ou encore du zamak qui est un alliage de zinc, d'aluminium et de magnésium et de cuivre.

Dans le cas de la figure 2(a), le composant 6 d'électronique de puissance est supporté par la face supérieure de la carte 5, plus généralement par la face de la carte 5 de circuit imprimé directement en regard avec la portion de l'écran 9. Dans ce cas, une couche 11 formant interface thermique est de préférence interposée entre une partie inférieure de la portion de l'écran 9 et la partie supérieure composant.

Selon la variante de la figure 2(b), le composant 6 d'électronique de puissance est supporté par l'autre face de la carte du circuit imprimé, c'est-à-dire la face de la carte 5 de circuit imprimé opposée à celle qui est directement en regard avec la portion de l'écran 9. Ici encore, une couche 11 formant interface thermique est de préférence interposée, cette fois-ci entre la partie inférieure de la portion dudit écran 9 et la face de la carte 5 de circuit imprimée directement en regard avec la portion de l'écran 9.

Dans les deux variantes, la couche 11 est formée d'une graisse thermique, d'une colle thermique, d'une pâte thermique, ou toute autre matière permettant de combler l'espace entre les éléments et assurer une bonne conduction thermique.

Dans tous les cas, c'est la portion métallique de carrosserie, ici le toit, qui sert de dissipateur thermique à l'énergie thermique qui transite, comme indiqué par les flèches en traits interrompus, entre le composant 6 et la carrosserie, via l'écran métallique 9.

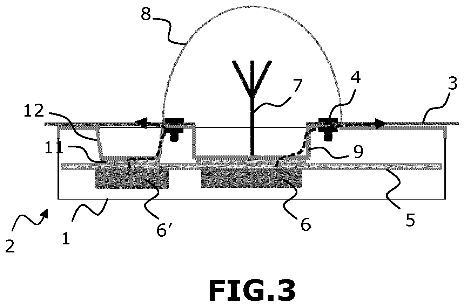

Dans un deuxième mode de réalisation illustré schématiquement sur la figure 3, le rebord de l'écran 9 métallique est en outre d'une dimension telle qu'il s'étend parallèlement à la carte 5 de circuit imprimé de manière à former une face (dans l'exemple la face supérieure) du boîtier 1.

Un intérêt de ce second mode de réalisation est que l'écran 9 peut servir également de vecteur d'énergie thermique pour d'autres composants à refroidir du dispositif 2, tels qu'un deuxième composant 6' d'électronique de puissance. Ce deuxième composant 6' est ici placé au droit et en contact thermique avec une portion inférieure d'une projection 12, s'étendant vers l'intérieur du boîtier 1, du rebord.

## Revendications

1. Dispositif (2) de télématique embarquée destiné à être fixé sur une partie métallique (3) d'une carrosserie de véhicule automobile, comportant un boîtier (1) intégrant une carte (5) de circuit imprimé dont une face porte au moins un composant (6) d'électronique de puissance, une antenne (7) d'émission/réception radiofréquence, destinée à s'étendre au travers d'une ouverture de la partie métallique (3) et un écran (9) métallique interposé entre une partie inférieure de l'antenne (7) d'une part, et la carte (5) de circuit imprimé et ledit au moins un composant, pour isoler l'antenne d'émissions parasites, ledit écran étant destiné à être fixé entre ladite partie métallique (3) et le boîtier (1) de façon à assurer une continuité électrique, dispositif dans lequel ledit au moins un composant (6) est placé au droit de l'écran (9) métallique et en contact thermique avec une portion dudit écran, et ledit écran (9) est en matériau conducteur thermique de façon à former un moyen de transfert thermique entre le composant (6) d'électronique de puissance et la partie métallique (3).

2. Dispositif selon la revendication 1, **caractérisé en ce que** l'écran (9) métallique comporte un rebord s'appuyant sur une face externe du boîtier et périphérique à l'ouverture, et **en ce que** le dispositif est apte à être fixé sur la partie métallique par des vis (4) de fixation traversant ensemble ledit rebord et la face externe du boîtier (1).

3. Dispositif selon l'une quelconque des revendications précédentes, **caractérisé en ce que** le matériau conducteur possède une conductivité thermique supérieure ou égale à 50 W.m⁻¹.K⁻¹.

4. Dispositif selon la revendication 3, **caractérisé en ce que** le matériau conducteur est de l'acier.

5. Dispositif selon la revendication 3, **caractérisé en ce que** le matériau conducteur est de l'aluminium.

6. Dispositif selon la revendication 3, **caractérisé en ce que** le matériau conducteur est du zamak.

7. Dispositif selon l'une quelconque des revendications précédentes, **caractérisé en ce que** ledit au moins un composant (6) d'électronique de puissance est supporté par une face de la carte (5) de circuit imprimé directement en regard avec la portion dudit écran (9), et **en ce qu'**une couche (11) formant interface thermique est interposée entre une partie inférieure de la portion dudit écran (9) et la partie supérieure dudit composant.

8. Dispositif selon l'une quelconque des revendications 1 à 7, **caractérisé en ce que** ledit au moins un composant (6) d'électronique de puissance est supporté par une première face de la carte (5) de circuit imprimé opposée à une deuxième face de la carte (5) directement en regard avec la portion dudit écran (9), et **en ce qu'**une couche (11) formant interface thermique est interposée entre une partie inférieure de la portion dudit écran (9) et la première face de la carte (5) de circuit imprimée.

9. Dispositif selon l'une quelconque des revendications 2 à 8, **caractérisé en ce que** le rebord de l'écran (9) métallique s'étend parallèlement à la carte (5) de circuit imprimé de manière à former une face dudit boîtier (1).

10. Dispositif selon la revendication 9, **caractérisé en ce que** ledit rebord comporte une projection s'étendant vers l'intérieur du boîtier (1), avec une portion inférieure de ladite projection placée au droit de et en contact thermique avec un autre composant (6') d'électronique de puissance porté par ladite carte (5) de circuit imprimé.

## Patentansprüche

1. Bordeigene Telematikvorrichtung (2) zur Befestigung an einem metallischen Abschnitt (3) einer Kraftfahrzeugkarosserie, aufweisend ein Gehäuse (1), das eine Leiterplatte (5), deren eine Seite mindestens ein Leistungselektronik-Bauelement (6) aufweist, eine Hochfrequenz-Sende-/Empfangsantenne (7), die dazu bestimmt ist, sich durch eine Öffnung des metallischen Abschnitts (3) zu erstrecken, und einen Metallschirm (9), der zwischen einem unteren Abschnitt der Antenne (7) einerseits und der Leiterplatte (5) und dem mindestens einen Bauelement angeordnet ist, um die Antenne vor Störemissionen zu isolieren, enthält, wobei der Schirm dazu bestimmt ist, zwischen dem metallischen Abschnitt (3) und dem Gehäuse (1) so befestigt zu sein, dass er eine elektrische Kontinuität gewährleistet, wobei in der Vorrichtung das mindestens eine Bauelement (6) gegenüber dem Metallschirm (9) und in Wärmekontakt mit einem Teilbereich des Schirms platziert ist, und der Schirm (9) aus wärmeleitendem Material ist, so dass er ein Wärmeleitungsmittel zwischen dem Leistungselektronik-Bauelement (6) und dem metallischen Abschnitt (3) bildet.

2. Vorrichtung nach Anspruch 1, **dadurch gekennzeichnet, dass** der Metallschirm (9) einen Rand aufweist, der auf einer Außenfläche des Gehäuses und am Umfang der Öffnung aufliegt, und dadurch, dass die Vorrichtung geeignet ist, durch Befestigungsschrauben (4), die durch den Rand und die Außenfläche des Gehäuses (1) zusammen hindurchgehen, am metallischen Abschnitt befestigt zu sein.

3. Vorrichtung nach einem der vorhergehenden Ansprüche, **dadurch gekennzeichnet, dass** das leitende Material eine Wärmeleitfähigkeit größer als oder gleich 50 W.m⁻¹.K⁻¹ aufweist.

4. Vorrichtung nach Anspruch 3, **dadurch gekennzeichnet, dass** das leitende Material Stahl ist.

5. Vorrichtung nach Anspruch 3, **dadurch gekennzeichnet, dass** das leitende Material Aluminium ist.

6. Vorrichtung nach Anspruch 3, **dadurch gekennzeichnet, dass** das leitende Material Zamak ist.

7. Vorrichtung nach einem der vorhergehenden Ansprüche, **dadurch gekennzeichnet, dass** das mindestens eine Leistungselektronik-Bauelement (6) von einer Fläche der Leiterplatte (5) direkt gegenüber dem Teilbereich des Schirms (9) getragen wird, und dadurch, dass eine Schicht (11), die eine Wärmeübergangsstelle bildet, zwischen einem unteren Abschnitt des Teilbereichs des Schirms (9) und dem oberen Abschnitt des Bauelements angeordnet ist.

8. Vorrichtung nach einem der Ansprüche 1 bis 7, **dadurch gekennzeichnet, dass** das mindestens eine Leistungselektronik-Bauelement (6) von einer ersten Fläche der Leiterplatte (5) gegenüber einer zweiten Fläche der Leiterplatte (5), die dem Teilbereich des Schirms (9) direkt gegenüberliegt, getragen wird, und dadurch, dass eine Schicht (11), die eine Wärmeübergangsstelle bildet, zwischen einem unteren Abschnitt des Teilbereichs des Schirms (9) und der ersten Fläche der Leiterplatte (5) angeordnet ist.

9. Vorrichtung nach einem der Ansprüche 2 bis 8, **dadurch gekennzeichnet, dass** sich der Rand des Metallschirms (9) parallel zur Leiterplatte (5) erstreckt, so dass er eine Fläche des Gehäuses (1) bildet.

10. Vorrichtung nach Anspruch 9, **dadurch gekennzeichnet, dass** der Rand einen Vorsprung aufweist, der sich zum Inneren des Gehäuses (1) erstreckt, wobei ein unterer Teilbereich des Vorsprungs gegenüber und in Wärmekontakt mit einem anderen Leistungselektronik-Bauelement (6') platziert ist, der von der Leiterplatte (5) getragen wird.

## Claims

1. Onboard telematic device (2) that is intended to be attached to a metal part (3) of a body of a motor vehicle, including a housing (1) incorporating a printed circuit board (5), one face of which bears at least one power electronic component (6), a radiofrequency transceiving antenna (7), which is intended to extend through an opening in the metal part (3), and a metal screen (9) that is interposed between a lower part of the antenna (7) on one side and the printed circuit board (5) and said at least one component in order to insulate the antenna from parasitic emissions, said screen being intended to be attached between said metal part (3) and the housing (1) so as to provide electrical continuity, in which device said at least one component (6) is placed in line with the metal screen (9) and in thermal contact with a portion of said screen, and said screen (9) is made of thermally conductive material so as to form a means for heat transfer between the power electronic component (6) and the metal part (3).

2. Device according to Claim 1, **characterized in that** the metal screen (9) includes a rim that bears against an outer face of the housing and is peripheral to the opening, and **in that** the device is capable of being attached to the metal part by means of fastening bolts (4) passing through said rim and the outer face of the housing (1) together.

3. Device according to either of the preceding claims, **characterized in that** the thermal conductivity of the conductive material is higher than or equal to 50 W.m^{- 1}.K⁻¹_{.}

4. Device according to Claim 3, **characterized in that** the conductive material is steel.

5. Device according to Claim 3, **characterized in that** the conductive material is aluminum.

6. Device according to Claim 3, **characterized in that** the conductive material is zamak.

7. Device according to any one of the preceding claims, **characterized in that** said at least one power electronic component (6) is borne by a face of the printed circuit board (5) that is directly facing the portion of said screen (9), and **in that** a thermal interface-forming layer (11) is interposed between a lower part of the portion of said screen (9) and the upper part of said component.

8. Device according to any one of Claims 1 to 7, **characterized in that** said at least one power electronic component (6) is borne by a first face of the printed circuit board (5) opposite a second face of the board (5) that is directly facing the portion of said screen (9), and **in that** a thermal interface-forming layer (11) is interposed between a lower part of the portion of said screen (9) and the first face of the printed circuit board (5).

9. Device according to any one of Claims 2 to 8, **characterized in that** the rim of the metal screen (9) runs parallel to the printed circuit board (5) so as to form one face of said housing (1).

10. Device according to Claim 9, **characterized in that** said rim includes a projection extending into the interior of the housing (1), with a lower portion of said projection placed in line with and in thermal contact with another power electronic component (6') borne by said printed circuit board (5)
